# EUROPÄISCHE PATENTSCHRIFT

(11) **EP 0 295 465 B1**
(45) Veröffentlichungstag und Bekanntmachung des Hinweises auf die Patenterteilung: **17.03.1993**
(21) Anmeldenummer: 88108281.2
(22) Anmeldetag: 25.05.1988
(51) Int. Cl.: G03F 7/022

(54) **Lichtempfindliches Gemisch auf Basis von 1,2-Naphthochinondiaziden, daraus hergestelltes Aufzeichnungsmaterial und dessen Verwendung**
Light sensitive composition with 1,2-naphthoquinonediazide, light sensitive registration material prepared therefrom and use thereof
Compositions photosensibles à base de 1,2 naphtoquinonediazides et matériel d'enregistrement préparé à partir de cette composition et son emploi

(30) Priorität: 02.06.1987 DE 3718416
(43) Veröffentlichungstag der Anmeldung: 21.12.1988
(73) Patentinhaber: HOECHST AKTIENGESELLSCHAFT, 65926 Frankfurt am Main (DE)
(72) Erfinder: Stahlhofen, Paul, Dr., Dipl.-Chem., D-6200 Wiesbaden (DE); Gaschler, Otfried, Dipl.-Ing., D-6200 Wiesbaden (DE)

(56) Entgegenhaltungen:
- PATENT ABSTRACTS OF JAPAN, Band 9, Nr. 323 (P-414)[2046], 18. Dezember 1985; & JP-A-60 150 047 (FUJI SHASHIN FILM K.K.) 07-08-1985
- PATENT ABSTRACTS OF JAPAN, Band 8, Nr. 55 (P-260)[1492], 13. März 1984; & JP-A-58 203 434 (KANTOU KAGAKU K.K.) 26-11-1983

## Beschreibung

Die Erfindung betrifft ein positiv arbeitendes lichtempfindliches Gemisch, das im wesentlichen einen Ester oder ein Amid einer 1,2-Naphthochinondiazidsulfon-oder carbonsäure als lichtempfindliche Verbindung, ein in wäßrig-alkalischen Lösungen lösliches, wasserunlösliches Phenolharz als Bindemittel und zusätzlich eine die Lichtempfindlichkeit steigernde Verbindung enthält. Die Erfindung betrifft auch ein lichtempfindliches Aufzeichnungsmaterial, das aus einem Schichtträger und einer Schicht aus dem lichtempfindlichen Gemisch hergestellt ist und dessen Verwendung.

Lichtempfindliche Gemische bzw. Aufzeichnungsmaterialien deren bildmäßig belichtete Bereiche in einer Entwicklerlösung löslich werden und in der die unbelichteten Bereiche unlöslich sind, sind seit langem bekannt. Für die Herstellung derartiger Materialien werden in der Praxis vor allem Schichten mit o-Chinondiaziden als lichtempfindliche Verbindungen verwendet, die als Bindemittel Harze mit alkalilöslich machenden Gruppen enthalten, wie zum Beispiel Phenolharze.

Derartige Kopierschichten haben jedoch eine relativ ungenügende Lichtempfindlichkeit. Deshalb wurden bereits verschiedene Vorschläge zur Verbesserung der photographischen Empfindlichkeit derartiger strahlungsempfindlicher Aufzeichnungsmaterialien aus einer o-Chinondiazidverbindung und einem alkalilöslichen Phenolharz gemacht. So kann zum Beispiel durch Erhöhung der Menge an der o-Chinondiazidverbindung oder durch Verminderung der Menge des alkalilöslichen Phenolharzes die Lichtempfindlichkeit der Aufzeichnungsschicht verbessert werden. Von Nachteil ist jedoch, daß hierbei die geforderte Entwicklerresistenz verschlechtert und der Entwicklerspielraum, d.h. die Zeitdauer bis zur optimalen Entwicklung, verringert wird. Für die Praxis sind derartige Maßnahmen daher problematisch.

Auch durch Kombination einer o-Chinondiazidverbindung mit Phenolharzen größerer Löslichkeit in einem wäßrig-alkalischen Entwickler läßt sich die Lichtempfindlichkeit scheinbar erhöhen, doch wird auch hier die Entwicklerresistenz schlechter und der Entwicklungsspielraum für die Praxis zu klein.

Es wurde auch bereits versucht, durch Zusatz bestimmter Sensibilisatoren zu dem lichtempfindlichen Gemisch die Lichtempfindlichkeit zu verbessern. Aus US-PS 3 661 582 ist bekannt, einem Gemisch mit o-Naphthochinondiazid bestimmte Heterocyclen, wie 2-Azacyclononan-2-on, Indol, Chinazolin oder Tetrazol, zuzusetzen, um deren Lichtempfindlichkeit zu erhöhen. Auch in diesem Falle resultiert nur ein extrem enger Entwicklerspielraum.

In der japanischen Patentanmeldung 42 449/1971 sind verschiedene Zusätze, z.B. Triphenylmethanfarbstoffe, Benzaldehyd-m-tolylhydrazon, halogenierte Kohlenwasserstoffe und Azofarbstoffe beschrieben, um die photographische Empfindlichkeit zu erhöhen; keine dieser Verbindungen hat jedoch eine bemerkenswerte Wirksamkeit.

In der DE-OS 26 57 922, entsprechend US-PS 4 115 128, wird der Zusatz von cyclischen Säureanhydriden für den gleichen Zweck beschrieben. Auch hier erreicht man eine Steigerung der Empfindlichkeit nur auf Kosten der Entwicklerresistenz. Ähnliche Ergebnisse erhält man, wenn zwecks Erhöhung der Lichtempfindlichkeit Gallussäure der Aufzeichnungsschicht zugesetzt wird, wie es aus der DE-OS 32 01 151 bekannt ist.

In der DE-OS 28 47 878, entsprechend US-PS 4 275 139, wird schließlich zur Erhöhung der Lichtempfindlichkeit der Zusatz eines Kondensationsproduktes aus Formaldehyd und einem Hydroxybenzophenon zum lichtempfindlichen Gemisch beschrieben. Der Zusatz derartiger Polykondensationsprodukte, bei denen die Hydroxybenzophenonmoleküle über eine Methylenbrücke miteinander verbunden sind und wobei mindestens eine OH-Gruppe dem C-Atom, das die Carbonylgruppe trägt, benachbart sein muß, führt zwar zu einer deutlichen Erhöhung der Lichtempfindlichkeit, von Nachteil ist jedoch, daß entweder relativ große Mengen an Zusatz erforderlich sind oder daß die Chemikalienresistenz der Druckschablone verschlechtert wird. Ferner hat sich gezeigt, daß in Gegenwart des Kondensationsproduktes aus 2,3,4-Trihydroxybenzophenon und Formaldehyd die resultierende Lichtempfindlichkeit stark abhängig ist von der Art der Entwicklung. So resultiert beispielsweise bei Tauch- bzw. Küvettenentwicklung eine wesentlich höhere Lichtempfindlichkeit, gemessen am Halbtonstufenkeil, als bei der Handentwicklung.

In den Patent Abstracts of Japan, Band 9, No. 323 (P 414) [2046], 18.12.1985; JP-A 60 150 047; 07.08.1985 werden zur Steigerung der Empfindlichkeit ohne Verminderung des Entwicklungsverhaltens aromatische Bis-polyhydroxyphenyl-alkane als Zusatz in o-Chinondiaziden enthaltenden lichtempfindlichen Gemischen beschrieben. Es hat sich jedoch gezeigt, daß mit dem Zusatz dieser Verbindungen noch nicht optimale Bedingungen hinsichtlich der kopier- und drucktechnischen Eigenschaften erfüllt werden können.

Der vorliegenden Erfindung liegt deshalb die Aufgabe zugrunde, die Lichtempfindlichkeit eines lichtempfindlichen Gemisches, das eine o-Naphthochinondiazidverbindung und ein alkalilösliches Phenolharz sowie ein nicht plastifiziertes Melamin-Formaldehyd-Harz enthält, zu verbessern, ohne daß andere wesentliche Eigenschaften der Kopierschicht hierbei nachteilig beeinflußt werden.

Die Lösung dieser Aufgabe geht aus von einem lichtempfindlichen Gemisch der eingangs beschriebenen Art, und sie ist dadurch gekennzeichnet, daß in dem Gemisch als Zusatz eine Verbindung aus der Reihe Biphenyldiol-(4,4'), Bis-(4-hydroxyphenyl)-keton oder Bis-(4-hydroxyphenyl)-sulfon vorhanden ist.

Die Konzentration der erfindungsgemäßen Bis-(4-hydroxyphenyl)-Verbindungen in dem lichtempfindlichen Gemisch kann in relativ weiten Grenzen schwanken. Sie liegt vorzugsweise zwischen 0,5 und 15, insbesondere zwischen 1 und 10 Gewichtsprozent, bezogen auf das Gewicht seiner nichtflüchtigen Bestandteile.

Die als Zusatz verwendeten Verbindungen sind im Handel erhältlich oder sie sind nach aus der Literatur bekannten Methoden herstellbar.

Als 1,2-Naphthochinondiazidverbindungen werden die Sulfonsäurederivate, insbesondere die Ester mit aromatischen Hydroxyverbindugen bevorzugt. Die Sulfonsäuregruppe befindet sich im allgemeinen in der 4- oder 5-Stellung des Naphthalinkerns, wobei die 5-Sulfonsäurederivate vorteilhafter sein können. Geeignete Naphthochinondiazide sind aus DE-PS 938 233 (entsprechend US-PS 739 654), 1 124 817 (US-PS 3 061 430), 1 109 521 (US-PS 3 130 047), 3 100 077 (US-PS 4 424 270, 1 120 273 (US-PS 3 130 048), 1 114 705 (US-PS 3 130 049) und 1 543 721 (US-PS 3 640 992), DE-OS 27 42 631 (US-PS 4 266 000) und 28 28 037 (US-PS 4 266 001) bekannt. Die Menge der Naphthochinondiazid-Verbindungen in dem Gemisch liegt im allgemeinen zwischen 3 und 50, vorzugsweise zwischen 8 und 25 Gewichtsprozent, bezogen auf den Gehalt an seinen nichtflüchtigen Bestandteilen.

Die bei vielen Positiv-Kopiermaterialien auf Basis von 1,2-Chinondiaziden bewährten Novolak-Kondensationsharze haben sich als Bindemittel auch hier als vorteilhaft erwiesen. Die Novolake können zusätzlich in bekannter Weise durch Umsetzung eines Teils ihrer Hydroxygruppen, z.B. mit Chloressigsäure, Isocyanaten, Epoxiden oder Carbonsäureanhydriden, modifiziert sein. Als weitere alkalilösliche bzw. in Alkali quellbare Bindemittel sind Polyhydroxyphenolharze, die durch Kondenstaion aus Phenolen und Aldehyden oder Ketonen hergestellt werden oder Mischpolymerisate aus Styrol und Maleinsäureanhydrid oder Polyvinylphenole einsetzbar. Vorteilhaft kann ein Polymerisat bzw. Copolymerisat eines mit einem mehrwertigen Phenol veresterten Acryl- bzw. Methacrylsäureesters eingesetzt werden.Die Art und Menge des alkalilöslichen Harzes kann je nach Anwendungszweck verschieden sein; bevorzugt werden Anteile am Gesamtfeststoff zwischen 90 und 30, insbesondere zwischen 85 - 55 Gewichtsprozent.

Weiterhin können noch zahlreiche andere Harze mitverwendet werden. Als besonders vorteilhaft hat sich eine Kombination aus einem Kresol-Formaldehyd-Novolak und einem nicht plastifizierten, vorzugsweise alkylveretherten Melamin-Formaldehyd-Harz erwiesen. Ferner können als Harze zusätzlich Epoxyharze und Vinylpolymerisate, wie Polyvinylacetate, Polyacrylate, Polyvinylacetale, Polyvinylether, Polyvinylpyrrolidone und die Mischpolymerisate der ihnen zugrundeliegenden Monomeren sowie hydrierte oder teilhydrierte Kolophoniumderivate vorhanden sein. Der günstigste Anteil an diesen Harzen richtet sich nach den anwendungstechnischen Erfordernissen und nach dem Einfluß auf die Entwicklungsbedingungen. Er beträgt im allgemeinen nicht mehr als 40 Gewichtsprozent, bevorzugt etwa 1 bis 20 Gewichtsprozent, bezogen auf alkalilösliches Bindemittel. In geringen Mengen kann das lichtempfindliche Gemisch für spezielle Erfordernisse, wie Flexibilität, Haftung, Glanz und Färbung, außerdem noch Substanzen wie Polyglykole, Cellulose-Derivate, wie Ethylcellulose, Netzmittel, Farbstoffe, Haftvermittler und feinteilige Pigmente sowie bei Bedarf UV-Absorber enthalten.

Ferner können dem lichtempfindlichen Gemisch für den Farbumschlag nach dem Belichten noch geringe Mengen von strahlungsempfindlichen Komponenten beigefügt werden, die beim Belichten vorzugsweise starke Säuren bilden bzw. abspalten und in einer Folgereaktion mit einem geeigneten Farbstoff einen Farbumschlag hervorrufen. Derartige strahlungsempfindliche Komponenten sind zum Beispiel 1,2-Naphthochinondiazid-4-sulfonsäurechlorid, chromophor substituierte Halogenmethyl-s-triazine oder Diazoniumverbindungen in Form ihrer Salze mit komplexen Säuren wie Borfluorwasserstoffsäure oder Hexafluorphosphorsäure.

Zur Beschichtung eines geeigneten Schichtträgers, d.h. zur Herstellung eines lichtempfindlichen Aufzeichnungsmaterials, wird das Gemisch im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemäße Gemisch sind Ketone, wie Methylethylketon, chlorierte Kohlenwasserstoffe, wie Trichlorethylen und 1,1,1-Trichlorethan, Alkohole, wie n-Propanol, Ether, wie Tetrahydrofuran, Alkoholether, wie Ethylenglykolmonoalkylether, Propylenglykolmonoalkylether und Ester, wie Butylacetat oder Propylenglykolalkyletheracetat. Es können auch Gemische verwendet werden, die zudem noch für spezielle Zwecke Lösungsmittel wie Acetonitril, Dioxan oder Dimethylformamid enthalten können. Prinzipiell sind alle Lösungsmittel verwendbar, die mit den Schichtkomponenten nicht irreversibel reagieren. Partialether von Glykolen, insbesondere Ethylenglykolmonomethylether und Propylenglykolmonomethylether werden besonders bevorzugt.

Als Schichtträger für Schichtdicken unter ca. 10 µm werden meist Metalle verwendet. Für Offsetdruckplatten können eingesetzt werden: walzblankes, mechanisch oder elektrochemisch aufgerauhtes und gegebenenfalls anodisiertes Aluminium, das zudem noch chemisch, z.B. mit Polyvinylphosphonsäure, Silikaten, Phosphaten, Hexafluorozirkonaten oder mit hydrolisiertem Tetraethylorthosilikat, vorbehandelt sein kann.

Die Beschichtung des Schichtträgers erfolgt in bekannter Weise durch Aufschleudern, Sprühen, Tauchen, Walzen mittels Breitschlitzdüsen, Rakeln oder durch Gießer-Antrag. Belichtet wird mit den in der Technik üblichen Lichtquellen.

Zum Entwickeln werden wäßrig-alkalische Lösungen abgestufter Alkalität verwendet, vorzugsweise mit einm pH im Bereich von 10 - 14, die auch kleine Mengen organischer Lösungs- oder Netzmittel enthalten können.

Zur Herstellung einer Druckform wird das lichtempfindliche Aufzeichnungsmaterial unter einer Positiv-Vorlage bildmäßig belichtet und anschließend mittels eines wäßrig-alkalischen Entwicklers entwickelt. Zur bildmäßigen Belichtung können Röhrenlampen, Xenonimpulslampen, metallhalogeniddotierte Quecksilberdampflampen oder Kohlenbogenlampen verwendet werden.

Durch die Erfindung wird eine deutliche Erhöhung der Lichtempfindlichkeit gegenüber den bekannten positiv arbeitenden Kopierschichten erreicht, ohne daß zugleich in bemerkenswerter Weise kopier- und drucktechnische Nachteile, d.h. Verschlechterung der Entwicklungsresistenz bzw. eine Verringerung des Entwicklungsspielraums, der Gradation, des Bildkontrastes oder der Druckauflagenhöhe, in Kauf genommen werden müssen.

Die Erfindung wird im einzelnen anhand der nachfolgenden Beispiele erläutert.

### Beispiel 1:

Mit einer Lösung von

| | |
|---|---|
| 1,600 Gt | des Veresterungsproduktes aus 1 Mol 2,3,4-Trihydroxybenzophenon und 3 Mol Naphthochinon-(1,2)-diazid-(2)-5-sulfonsäurechlorid, |
| 6,400 Gt | eines Kresol-Formaldehyd-Novolaks mit einem Erweichungspunkt von 127 - 145 °C, |
| 0,200 Gt | Naphthochinon-(1,2)-diazid-(2)-4-sulfonsäurechlorid, |
| 0,070 Gt | Kristallviolett, |
| 0,400 Gt | Bis-(4-hydroxyphenyl)-sulfon und |
| 0,200 Gt | eines nicht plastifizierten isobutylveretherten Melamin-Formaldehyd-Harzes in |
| 40,00 Gt | Ethylenglykolmonomethylether und |
| 55,00 Gt | Tetrahydrofuran |

wurde eine elektrochemisch aufgerauhte und anodisierte Aluminiumplatte beschichtet. Der anodisierte Schichtträger war vor dem Aufbringen der lichtempfindlichen Schicht mit einer wäßrigen Lösung von 0,1 Gewichtsprozent Polyvinylphosphonsäure behandelt worden.

Das so hergestellte vorsensibilisierte Aufzeichnungsmaterial mit einem Schichtgewicht von ca. 3,0 g/m² wurde unter einer transparenten Positiv-Vorlage in Gegenwart eines UGRA-Offset-Testkeils mit Hilfe einer Metall-Halogenid-Lampe von 500 Watt bei einem Lampenabstand von 103 cm mit 55 Takten (bzw. 47 Sekunden) lang belichtet und anschließend mit einer 3 %igen wäßrigen Natriumsilikatlösung durch Überwischen entwickelt.

Durch die Entwicklung wurden die vom Licht getroffenen Anteile der Kopierschicht entfernt, und es blieben die unbelichteten Bildstellen auf dem Schichtträger zurück, wodurch man die der Vorlage entsprechende Druckschablone erhielt.

Die optimale Belichtungszeit wurde als der Wert ermittelt, bei dem nach der Entwicklung das Mikrolinienfeld 8 µm völlig wegkopiert ist.

Wird eine gleiche Druckform, jedoch ohne den erfindungsgemäßen Zusatz an Bis-(4-hydroxyphenyl)-sulfon, bei gleicher Schichtdicke und auf dem gleichen Schichtträger und bei sonst gleichen Versuchsbedingungen hergestellt, so beträgt die Belichtungszeit, bei der das Mikrolinienkreisfeld 12 µm auf der entwickelten Druckform voll gedeckt ist (bzw. das Mikrolinienfeld 8 µm völlig wegkopiert ist) 80 Takte bzw. 67 Sekunden. Durch den erfindungsgemäßen Zusatz der Bis-(4-hydroxyphenyl)-Verbindung zu der lichtempfindlichen Schicht konnte die Lichtempfindlichkeit um ca. 30 % gesteigert werden, ohne daß die Entwicklerresistenz und der Entwicklungsspielraum nachteilig beeinflußt werden.

Wird das verwendete Bis-(4-hydroxyphenyl)-sulfon durch die gleiche Menge des in DE-OS 28 47 878 beschriebenen Kondensationsproduktes aus 2,3,4-Trihydroxybenzophenon und Formaldehyd ersetzt und mit der entsprechenden Lösung unter sonst gleichen Versuchsbedingungen eine Druckform hergestellt und wie vorstehend beschrieben belichtet, so resultiert nach dem Entwickeln in einer Küvette annähernd das gleiche Testbild wie oben angegeben. Wird jedoch unter sonst gleichen Versuchsbedingungen nach der Belichtung per Hand mittels eines Tampons entwickelt, so erhält man eine Druckform, die gemessen am resultierenden Testkeil bzw. Vergleich zu dem nach der Küvettenentwicklung erhaltenen Testkeil, zu kurz belichtet wurde.

Hieraus ergibt sich: Um bei Handentwicklung das gleiche Testergebnis bzw. die gleiche Tonwertübertragung wie bei der Küvettenentwicklung zu erreichen, muß man bei Anwesenheit des Vergleichsmaterials ca. 22 % länger belichten.

Diese Abhängigkeit der Belichtungszeit von der Art der Entwicklung ist von großem Nachteil für die Praxis. Durch Einsatz der erfindungsgemäßen Verbindungen wird dieses nicht praxisgerechte Verhalten vermieden. Die erfindungsgemäß hergestellte Druckform zeigt sowohl nach der Küvettenentwicklung als auch nach der Handentwicklung praktisch das gleiche Testergebnis.

### Beispiel 2

Mit einer Lösung von:

| | |
|---|---|
| 1,600 Gt | des Veresterungsproduktes aus 1 Mol 2,3,4-Dihydroxy-3,5-dibrombenzophenon und 2 Mol Naphthochinon-(1,2)-diazid-(2)-5-sulfonsäurechlorid, |
| 6,400 Gt | des im Beispiel 1 angegebenen Novolaks |
| 0,200 Gt | Naphthochinon-(1,2)-diazid-(2)-4-sulfonsäurechlorid, |
| 0,070 Gt | Kristallviolett und |
| 0,400 Gt | Biphenyldiol-(4,4') in |
| 40,00 Gt | Propylenglykolmonomethylether und |
| 55,00 Gt | Tetrahydrofuran |

wurde eine elektrochemisch aufgerauhte und anodisierte Aluminiumplatte beschichtet. Die Platte war vor dem Aufbringen der lichtempfindlichen Schicht mit einer wäßrigen Lösung von 0,1 Gewichtsprozent Polyvinylphosphonsäure behandelt worden.

Das so hergestellte lichtempfindliche Aufzeichnungsmaterial mit einem Schichtgewicht von ca. 3,0 g/m² wurde, wie in Beispiel 1 beschrieben, unter einer transparenten Positiv-Testvorlage mit 55 Takten belichtet und anschließend mit einer wäßrigen 3 %igen Natriumsilikatlösung durch Überwischen entwickelt.

Wird eine entsprechende Druckform, jedoch ohne den Zusatz von Biphenyldiol-(4,4') bei gleicher Schichtdicke und bei sonst gleichen Versuchsbedingungen, hergestellt und unter derselben Testvorlage belichtet, so muß für eine optimale Belichtungszeit 80 Takte lang belichtet werden.

Wird das Biphenyldiol-(4,4') durch die gleiche Menge Gallussäure ersetzt, wie es aus DE-OS 32 01 151 bekannt ist, so erhält man zwar die gleiche Verbesserung der Lichtempfindlichkeit, die Druckschablone hat jedoch im Gegensatz zu der hier hergestellten Druckform keine Entwicklerresistenz und wird bereits nach 3 minütiger Einwirkung des alkalischen Entwicklers völlig vom Schichtträger heruntergelöst.

Wird das verwendete Biphenyldiol-(4,4') durch 1,2,3,6-Tetrahydrophthalsäureanhydrid ersetzt, wie es zwecks Verbesserung der Lichtempfindlichkeit diazohaltiger Schichten aus DE-OS 26 57 922 (US-PS 4 115 128) bekannt ist, so resultiert bei sonst gleichen Versuchsbedingungen eine Belichtungszeit von 68 Takten.

### Beispiel 3:

Mit einer Lösung von

| | |
|---|---|
| 1,600 Gt | des Veresterungsproduktes aus 1 Mol 2,3,4-Trihydroxybenzophenon und 3 Mol Naphthochinon-(1,2)-diazid-(2)-5-sulfonsäurechlorid, |
| 6,400 Gt | des im Beispiel 1 angegebenen Novolaks |
| 0,200 Gt | Naphthochinon-(1,2)-diazid-(2)-4-sulfonsäurechlorid, |
| 0,070 Gt | Kristallviolett, |
| 0,400 Gt | Bis-(4-hydroxyphenyl)-keton und |
| 0,200 Gt | eines nicht plastifizierten isobutylveretherten Melamin-Formaldehyd-Harzes in |
| 40,00 Gt | Ethylenglykolmonomethylether und |
| 55,00 Gt | Tetrahydrofuran |

wurde eine elektrochemisch aufgerauhte und anodisierte Aluminiumplatte beschichtet, die wie in Beispiel 1 beschrieben, vorbehandelt wurde.

Die hergestellte Druckplatte mit einem Schichtgewicht von 3,0 g/m² wurde unter einer transparenten Positiv-Vorlage in Gegenwart eines UGRA-Offset-Testkeils, wie in Beispiel 1 angegeben, solange belichtet, bis nach der Entwicklung das Mikrolinienfeld 12 µm des mitkopierten Testkeils voll gedeckt auf der Platte steht bzw. bis das Mikrolinienfeld 8 µm völlig wegkopiert ist. Die erforderliche Belichtungszeit betrug hierfür 56 Takte. Ohne den Zusatz des Bis-(4-hydroxyphenyl)-ketons betrug die Belichtungszeit bei sonst gleichen Versuchsbedingungen 78 Takte.

Wird das Bis-(4-hydroxyphenyl)-keton durch 2,4-Dihydroxybenzophenon oder durch 2,3,4-Trihydroxybenzophenon ersetzt, und unter sonst gleichen Versuchsbedingungen belichtet, so muß man 69 Takte lang belichten, damit nach dem Entwickeln das Mikrolinienfeld 8 µm völlig wegkopiert ist.

## Patentansprüche

1. Lichtempfindliches Gemisch, das im wesentlichen einen Ester oder ein Amid einer 1,2-Naphthochinondiazidsulfon- oder-carbonsäure als lichtempfindliche Verbindung, ein in wäßrig-alkalischen Lösungen lösliches, wasserunlösliches Phenolharz als Bindemittel, ein nicht plastifiziertes Melamin-Formaldehyd-Harz und zusätzlich eine die Lichtempfindlichkeit steigernde Verbindung enthält, dadurch gekennzeichnet, daß in dem Gemisch als Zusatz eine Verbindung aus der Reihe Biphenyldiol-(4,4'), Bis-(4-hydroxyphenyl)-keton oder Bis-(4-hydroxyphenyl)-sulfon vorhanden ist.

2. Gemisch nach Anspruch 1, dadurch gekennzeichnet, daß der Zusatz in einer Menge von 0,5 bis 15 Gewichtsprozent, bezogen auf das Gewicht seiner nichtflüchtigen Bestandteile vorhanden ist.

3. Gemisch nach Ansprüchen 1 oder 2, dadurch gekennzeichnet, daß als Bindemittel ein Novolak-Kondensationsharz oder ein Polymerisat bzw. Copolymerisat eines mit einem mehrwertigen Phenol veresterten Acryl- bzw. Methacrylsäureesters vorhanden ist.

4. Gemisch nach Anspruch 1, dadurch gekennzeichnet, daß es ein alkylverethertes Melamin-Formaldehyd-Harz enthält.

5. Lichtempfindliches Aufzeichnungsmaterial aus einem Schichtträger und einer lichtempfindlichen Schicht, dadurch gekennzeichnet, daß die lichtempfindliche Schicht aus einem Gemisch nach einem der Ansprüche 1 bis 4 hergestellt ist.

6. Verwendung eines lichtempfindlichen Aufzeichnungsmaterials nach Anspruch 5 zur Herstellung einer Druckform.

## Claims

1. A photosensitive mixture which essentially comprises an ester or an amide of a 1,2-naphthoquinonediazide sulfonic acid or a 1,2-naphthoquinonediazide carboxylic acid as the photosensitive compound, a phenolic resin which is soluble in aqueous-alkaline solutions and insoluble in water as the binder, a non-plastified melamine/formaldehyde resin and additionally a photospeed-enhancing compound, wherein a compound selected from the group including biphenyldiol-(4,4'), bis-(4-hydroxyphenyl)-ketone or bis-(4-hydroxyphenol)-sulfone is present in said mixture as the admixture.

2. A mixture as claimed in Claim 1, wherein the admixture is contained in an amount of 0.5 to 15 percent by weight, relative to the weight of the non-volatile constituents.

3. A mixture as claimed in Claims 1 or 2, wherein a novolak condensation resin or a polymer or copolymer of an acrylate or methacrylate esterified with a polyvalent phenol is contained as binder.

4. A mixture as claimed in Claim 1, wherein an alkyletherified melamine/formaldehyde resin is contained.

5. A photosensitive recording material comprised of a layer support and a photosensitive layer, characterized in that the photosensitive layer is prepared from a mixture as claimed in any of Claims 1 to 4 .

6. Use of a photosensitive recording material as claimed in Claim 5 for the production of a printing form.

## Revendications

1. Composition photosensible, qui comprend essentiellement un ester ou un amide d'un acide 1,2-naphtoquinonediazidesulfonique ou -carboxylique, comme composé photosensible, une résine phénolique soluble dans les solutions alcalines aqueuses mais insoluble dans l'eau, comme liant, une résine mélamine-formaldéhyde non plastifiée et en outre un composé augmentant la photosensibilité, caractérisée en ce qu'un composé choisi parmi: biphényldiol-(4,4'), bis-(4-hydroxyphényl)-cétone ou bis-(4-hydroxyphényl)-sulfone est présent, comme adjuvant, dans la composition.

2. Composition selon la revendication 1, caractérisée en ce que l,adjuvant est présent à raison de 0,5 à 15 % en poids par rapport au poids des constituants non volatils de ladite composition.

3. Composition selon la revendication 1 ou 2, caractérisée par la présence, comme liant, d'une résine de condensation novolaque ou d'un polymère ou copolymère d'un ester d'acide acrylique ou méthacrylique avec un polyphénol.

4. Composition selon la revendication 1, caractérisée en ce qu'elle contient une résine mélamine-formaldéhyde éthérifiée par des groupes alkyle.

5. Matériau de reprographie photosensibie comprenant un support de couche et une couche photosensible, caractérisé en ce que la couche photosensible se compose d'un mélange selon une des revendications 1 à 4.

6. Utilisation d'un matériau de reprographie photosensibie selon la revendication 5, pour la fabrication d'une forme d'impression.
